# EUROPEAN PATENT SPECIFICATION

(11) **EP 1 877 699 B1**
(45) Date of publication and mention of the grant of the patent: **26.11.2008**
(21) Application number: 05750133.0
(22) Date of filing: 06.05.2005
(51) Int. Cl.: F21V 31/03, H05K 5/02, F16H 57/02

(54) **VENT FILTER WITH MEMBRANE**
ENTLÜFTUNGSFILTER MIT MEMBRAN
FILTRE DE MISE À L'AIR AVEC MEMBRANE

(43) Date of publication of application: 16.01.2008
(73) Proprietor: GVS S.p.A., 40069 Zola Predosa (Bologna) (IT)
(72) Inventor: SCAGLIARINI, Marco, I-40135 Bologna (IT)
(74) Representative: Ripamonti, Enrico
(86) International application number: PCT/IT2005/000265
(87) International publication number: WO 2006/120707

(56) References cited:
- EP-A- 0 717 231
- EP-A- 0 860 923
- EP-A- 1 184 602
- DE-A1- 19 702 685
- US-A- 4 900 441
- US-A- 5 406 467
- US-A- 6 071 000
- US-B1- 6 174 231
- PATENT ABSTRACTS OF JAPAN vol. 1995, no. 09, 31 October 1995 (1995-10-31) & JP 07 147106 A (KANTO AUTO WORKS LTD; others: 02), 6 June 1995 (1995-06-06)

## Description

The present invention relates to a filter for venting an enclosure containing an electrical, mechanical, electromechanical or similar apparatus in accordance with the introduction to the main claim.

It is known to use filters of the aforesaid type for venting or ventilating in the automobile industry (or in vehicles in general, this term meaning an automobile, a truck, a motorcycle or the like); these filters are associated for example with venting apertures of containers containing electrical or electronic parts (such as the lens or lighting or headlight units of motor vehicles) or mechanical parts (gear boxes, for example) where pressure has to be equalized between the interior of these containers and the external environment. These filters are also known to present a conformation or elements at least such as to limit water entry into said containers, said water being able to derive from rain or puddles or being able to derive from the washing of the vehicle or its engine. For example, a filter is known presenting a hollow tubular (elbow) bent conformation and shaped internally as a labyrinth to prevent or at least limit water access from the outside to the inside of the container via the tubular (venting) cavity of the filter.

Filters of the said type are also known using membranes of hydrophobic material associated with an internal conduit of the filter communicating with the container interior. Examples of these filters are those described in US5914415 and US5522769. In such filters of the state of the art and in particular in those described in the aforesaid US patents, the membrane is an element separate from the filter body and must be associated therewith by usually complex operations which require time and considerable care to prevent the membrane from breaking during handling. These operations are therefore costly.

For example, in US5522769 the hydrophobic membrane (preferably of polytetrafluoro ethylene) is inserted into a channel or seat lying transverse to a venting or passage conduit of the filter. The seat has a suitable diameter to securely contain the membrane. This known solution, in which the filter body has a substantially cap conformation and the venting conduit is rectilinear, is difficult to construct precisely because of the operations for coupling the membrane to the interior of the known filter body.

This latter also presents a rectilinear venting conduit which does not provide optimal protection to the container to which the filter is connected when this latter is subjected to a direct flow of liquid, such as that to which that part of a front headlight of a vehicle facing the engine may be subjected when this latter is exposed to washing with relatively high water pressure.

This lack of protection against water infiltration can also appear in the case of tightness tests to which motor vehicle headlights or lens units or lighting systems are subjected, tests during which a high pressure water flow strikes the headlight container to verify its tightness. Again in this case, the conformation of the filter venting conduit is not such as to adequately protect the filtering membrane from the pressurized liquid should this latter cause breakage of the diaphragm provided in US5522769 for protecting the hydrophobic membrane. In this respect, the diaphragm can protect the membrane if the filter is immersed in a liquid or if the liquid is able to directly strike the membrane, as stated in the prior.patent. However in this latter, the liquid which could strike the membrane is not stated to be a liquid under pressure, as is clear from the example offered in the text of the prior patent, in which this liquid is stated to be oil which is accidentally poured onto the filter.

US5914415 also describes a filter provided with a hydrophobic membrane or water repellent film associated, for example by subsequent fusion, with the filter body which is formed of elastomeric material. The film is finally protected by a cover cap fixed by pins (rigid with the cap) inserted into seats in the elastomeric body. The filter described in the prior patent is constructed as a plurality of parts assembled together, resulting in high costs and production times, together with constructional difficulties related to the operations of coupling the water repellent membrane or film to the elastomeric body and of coupling the cap to this latter body. US 4900441 and DE-A-19702685 describe filters whereby a membrane is co-moulded with a tubular body.

An object of the present invention is to provide a filter for venting an enclosure, for example containing electrical apparatus such as an enclosure used in the automobile field as a lens unit (or lighting system in general) or container for electrical circuitry for controlling a vehicle engine, which is improved compared with already known similar filters.

A particular object of the invention is to provide a filter of the stated type which can be produced relatively quickly at low cost.

Another object is to provide a filter of the stated type which offers a mechanical strength and a liquid seal which are optimal under all conditions of utilization of the container with which the filter is associated and in all other situations in which this container is struck by a liquid under pressure.

These and further objects which will be apparent to the expert of the art are attained by a filter in accordance with the accompanying claims.

The present invention will be more apparent from the accompanying drawings, which are provided by way of nonlimiting example and in which:

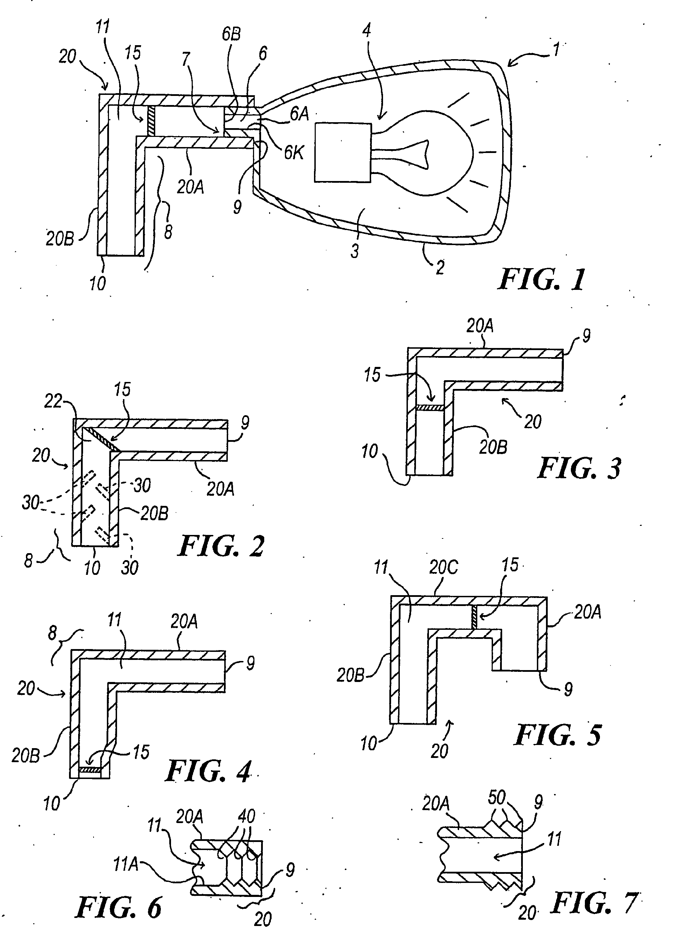

Figure 1 is a schematic cross-section through an example of a filter applied to an enclosure defined by a vehicle lens unit, also shown schematically; and
Figure 2 is a cross-section through an embodiments of the invention. Figures 3 to 7 are examples of filters. With reference to said figures, an enclosure to be vented is indicated overall by 1. In the example it is schematically shown as a lens unit or headlight or lighting system of a motor vehicle, but can be any container of an electrical or mechanical apparatus of a vehicle. The enclosure 1 comprises a body 2, internally hollow at 3, where an electrical apparatus 4 (a light bulb in the example) is located. The cavity 3 communicates with the outside of the body 2 via a conduit 6 provided in an appendix 7 projecting from this body, said conduit 6 being open at both its ends 6A (communicating with the cavity 3) and 6B (communicating with the outside of the enclosure).

In correspondence with the end 6B of the appendix 7 there is connected a filter 8 formed in accordance with the invention. It is such as to enable said cavity 3 to be vented, but to prevent water entry and to reduce the entry of moisture into it.

More particularly, the filter 8 presents a body 20 having at least two internally hollow tubular portions 20A, 20B. These are disposed at an angle to each other; a first portion 20A is connected, via its free end 9, directly to the appendix 7 of the body 2 of the enclosure 1, whereas the second portion 20B presents a free end 10 at which there opens an internal conduit 11 of the filter 8. This internal conduit 11 communicates with that 6 of the appendix 7, enabling air to pass from the outside to the inside of said body 2 and vice versa. In this manner the internal cavity 3 of the enclosure 1 can be correctly aerated. The angled arrangement of the at least two portions 20A, 20B of the filter 8 also prevents any water droplets present outside the filter from being able to easily pass to the interior of the enclosure 1. Said conformation also prevents any water jets used to wash the automobile or its engine from penetrating into the enclosure 1 when the lens or lighting unit is sufficiently protected by the bodywork of such a vehicle (automobile, motorcycle, heavy vehicle or truck, or the like).

To ensure that this water passage does not take place, a filtering element of hydrophobic membrane type 15 (of known type) is positioned in the internal conduit 11 of the filter 8, in any position between its ends 9, 10, transversely to the conduit 11, to prevent passage of water from the end 10 to the end 9 (and from there into the enclosure 1). According to an important characteristic of the invention, the filtering element or, more simply, the membrane 15 forms one piece with the body 20 of the filter 8. Preferably, the membrane is incorporated, in correspondence with its edge, into said body (constructed of plastic material). The membrane 15 hence forms one piece with said body 20, so as to be stably associated with it.

To obtain said integration between the body 20 and the membrane 15, the filter 8 is preferably constructed in accordance with the teachings of EP1184602. According to this latter, the filter 8 is obtained by moulding with a mould shaped to enable the free edge of the membrane 15 to be incorporated into the plastic material in the molten state which is injected into the mould, said material wrapping said edge of the membrane and incorporating it into itself when the material cools. The mould obviously has a shape such as to enable the body 20 to be obtained with at least two portions at an angle to each other.

As stated, the membrane 15 can be disposed in any position in the interior of the conduit 11 within its rectilinear portion or in correspondence with a discontinuity thereof. Different examples of this positioning are shown in particular in Figures from 2 to 4; According to the invention, in Figure 2 the membrane 15 is positioned in correspondence with the angled region 22 of the conduit 11, the region in which the two portions 20A and 20B of the filter body 20 join together. This solution enables a hydrophobic membrane or filtering element 15 to be obtained having effective dimensions greater than the transverse dimensions of the conduit 11, so enabling a greater surface for gas transfer between the inside and outside of the enclosure 1 to be obtained.

In Figure 3 the membrane 15 is positioned in correspondence with the portion 20B of the body 20 of the filter 8, in contrast to that of the filter of Figure 1 where the membrane 15 is positioned in correspondence with the portion 20A of that body.

In Figure 4, however, the membrane 15 is close to one of the ends (in the example the end 10) of the body 20 of the filter 8, while again remaining inside the conduit 11.

With regard to the portions 20A, 20B of the body 20 of the filter 8, these can present a corresponding conduit 11 with constant cross-section (Figures 1 and 3) or variable cross-section (Figure 4). In this latter case, varying the cross-section of the conduit also varies the flow rate of fluid or gas from one end of the conduit 11 of the filter 8 to the other.

Moreover, advantageously, one or more of the portions 20A, 20B of the body 20 can present a labyrinth conformation within the corresponding part of the conduit 11 so as to improve the liquid seal of the filter. In that case, the labyrinth is defined by a series of fins 30 (shown dashed in Figure 2) projecting towards the centre.of the conduit and disposed between the end 10 and the membrane 15.

Moreover, to increase the capacity to prevent possible liquid passage from the end 10 to the end 9 of the body 20 of the filter 8, this latter can also have more than two angled portions between the portions 20A and 20B; Figure 5 shows an embodiment in which the portions are of odd number (for example three), between the portions 20A and 20B there also being present a third portion 20C.

The filter 8 can be coupled to the appendix 7 in any known manner, for example by drawing its first portion 20A over said appendix (as shown in Figure 1). To achieve a better liquid seal, the free end 9 of said portion 20A can present a plurality of circular projections 40 in the interior of the conduit 11 (i.e. jutting from its wall 11A) arranged to cooperate with the free surface of the appendix 7.

Alternatively, if the portion 20A is coupled to the appendix 7 by being inserted into the conduit 6, the projections 50 can be provided on the outside of the portion 20 to cooperate with the wall 6K of said conduit 6 in order to seal against it.

One embodiment of the invention has been described. Others are however obtainable, such as that in which the body 20 assumes a disjointed conformation and comprises more than one membrane 15, or that in which the membrane 15 is co-moulded with the body 20 of the filter 8. These solutions are also to be considered as falling within the scope of the following claims.

## Claims

1. A filter for venting an enclosure (1) containing an electrical apparatus (4), such as a lens unit or lighting system of a motor vehicle, or a mechanical or electromechanical member of a vehicle, said enclosure (1) being exposed to moisture or atmospheric agents, said filter (8) comprising a tubular body (20) with a through cavity or conduit (11) opening at opposite ends (9, 10) of said body (20), this latter being coupled to a venting conduit (6) of said enclosure (1), the filter (8) comprising a filtering element in the form of a hydrophobic membrane (15), the membrane filtering element (15) being incorporated into the body (20) of the filter (8), this determining an integral combination between said body and said filter, the filter so obtained enabling said enclosure to be vented, but to prevent water entry and to reduce the entry of moisture into it, **characterised in that** said body (20) comprises at least two portions (20A, 20B) set at an angle to each other, the membrane filtering element (15) being in the interior of the conduit (11) provided within said body (20) and being associated with said conduit in such as manner as to form one piece therewith, the filtering element (15) being disposed transversely within the conduit (11), the membrane filtering element (15) being positioned in correspondence with a discontinuity of said conduit (11), said discontinuity being an angled region (22) of said conduit, said region (22) being present in the connection zone between two adjacent angled portions (20A, 20B) of the body (20) of the filter (8), the membrane filtering element (15) having a surface area greater than the cross-sectional area of each rectilinear portion of the conduit (11).

2. A filter as claimed in claim 1, **characterised in that** the membrane filtering element (15) is co-moulded with the body (20) of the filter (8).

3. A filter as claimed in claim 1, **characterised by** comprising within said conduit (11) a plurality of projections (30) jutting from the wall of this latter towards its interior, said projections (30) defining a labyrinth in the interior of said conduit and being present between a free end (10) of the body (20) and the membrane filtering element (15), the projections (30) improving the blocking action against water which may have entered the conduit (11) from this end (10).

4. A filter as claimed in claim 1, **characterised in that** the conduit (11) is of variable cross-section.

5. A filter as claimed in claim 1, **characterised in that** its body (20) is coupled to an appendix (7) of said enclosure (1) in which the venting conduit (6) of this latter is provided.

6. A filter as claimed in claim 5, **characterised in that** the body (20) presents a portion (20A) drawn over said appendix (7) which is hence inserted into the conduit (11) of said body, projections (40) jutting from a wall (11A) of said conduit (11) to cooperate with said appendix (7) in order to seal against it when coupling is complete.

7. A filter as claimed in claim 5, **characterised in that** the body (20) presents a portion (20A) inserted into the venting conduit (6) of said appendix (7), which is hence external to said portion (20A), on the outside of this latter there being provided projections (50) arranged to cooperate with the wall (6K) of said conduit (6) in order to seal against it when coupling is complete.

## Patentansprüche

1. Filter zum Belüften eines Gehäuses (1), welches ein Elektrogerät (4) enthält, wie zum Beispiel eine Linseneinheit oder ein Beleuchtungssystem eines Kraftfahrzeugs, oder ein mechanisches oder elektromechanisches Element eines Fahrzeugs, wobei das Gehäuse (1) Feuchtigkeit oder atmosphärischen Substanzen ausgesetzt ist, wobei das Filter (8) einen röhrenförmigen Körper (20) mit einem durchgehenden Hohlraum oder einer durchgehenden Leitung (11) aufweist, der/die sich an entgegengesetzten Enden (9, 10) des Körpers (20) öffnet, wobei letzterer mit einer Belüftungsleitung (6) des Gehäuses (1) verbunden ist, wobei das Filter (8) ein Filterelement in der Form einer wasserabstoßenden Membran (15) aufweist, wobei das Membranfilterelement (15) in den Körper (20) des Filters (8) eingebaut ist, wobei dies eine integrale Kombination zwischen dem Körper und dem Filter festlegt, wobei das derart erzielte Filter das Belüften des Gehäuses erlaubt, aber das Eindringen von Wasser verhindert und das Eindringen von Feuchtigkeit reduziert, **dadurch gekennzeichnet, dass** der Körper (20) mindestens zwei Abschnitte (20A, 20B) aufweist, die in einem Winkel zueinander angeordnet sind, wobei sich das Membranfilterelement (15) in dem Inneren der Leitung (11), die innerhalb des Körpers (20) bereitgestellt ist, befindet und mit der Leitung derart verbunden ist, dass es damit einen einzigen Teil bildet, wobei das Filterelement (15) quer innerhalb der Leitung (11) angeordnet ist, dass das Membranfilterelement (15) entsprechend einer Unterbrechung der Leitung (11) positioniert ist, wobei die Unterbrechung ein abgewinkelter Bereich (22) der Leitung ist, wobei der Bereich (22) in der Verbindungszone zwischen zwei angrenzenden abgewinkelten Abschnitten (20A, 20B) des Körpers (20) des Filters (8) gegenwärtig ist, wobei das Membranfilterelement (15) eine Fläche hat, die größer ist als die Querschnittfläche jedes geradlinigen Abschnitts der Leitung (11).

2. Filter nach Anspruch 1, **dadurch gekennzeichnet, dass** das Membranfilterelement (15) gemeinsam mit dem Körper (20) des Filters (8) geformt wird.

3. Filter nach Anspruch 1, **dadurch gekennzeichnet, dass** es innerhalb der Leitung (11) mehrere Vorsprünge (30) aufweist, die aus der Wand dieser letzteren zu deren Innerem vorstehen, wobei die Vorsprünge (30) ein Labyrinth im Inneren der Leitung bilden und zwischen einem freien Ende (10) des Körpers (20) und dem Membranfilterelement (15) gegenwärtig sind, wobei die Vorsprünge (30) die Blockierwirkung gegenüber Wasser, das eventuell in die Leitung (11) von diesem Ende (10) her eingedrungen ist, verbessert.

4. Filter nach Anspruch 1, **dadurch gekennzeichnet, dass** die Leitung (11) einen variablen Querschnitt hat.

5. Filter nach Anspruch 1, **dadurch gekennzeichnet, dass** sein Körper (20) mit einem Ansatz (7) des Gehäuses (1), in dem die Belüftungsleitung (6) dieses letzteren bereitgestellt ist, verbunden ist.

6. Filter nach Anspruch 5, **dadurch gekennzeichnet, dass** der Körper (20) einen Abschnitt (20A) aufweist, der über den Ansatz (7) gezogen ist, der somit in die Leitung (11) des Körpers eingefügt ist, wobei Vorsprünge (40) aus der Wand (11A) der Leitung (11) vorstehen, um mit dem Ansatz (7) zusammenzuwirken und gegen ihn abzudichten, wenn die Ankopplung vollständig ist.

7. Filter nach Anspruch 5, **dadurch gekennzeichnet, dass** der Körper (20) einen Abschnitt (20A) aufweist, der in die Belüftungsleitung (6) des Ansatzes (7) eingefügt ist, der somit außerhalb des Abschnitts (20A) liegt, wobei auf der Außenseite dieses letzteren Vorsprünge (50) bereitgestellt sind, die eingerichtet sind, um mit der Wand (6K) der Leitung (6) zusammenzuwirken und dagegen abzudichten, wenn die Ankopplung vollständig ist.

## Revendications

1. Filtre de mise à l'air libre d'un boîtier (1) contenant un appareil électrique (4), tel qu'un système optique ou un système d'éclairage de véhicule motorisé, ou un organe mécanique ou électromécanique de véhicule, ledit boîtier (1) étant exposé à l'humidité ou à des agents atmosphériques, ledit filtre (8) comprenant un corps tubulaire (20) avec une cavité ou un conduit traversant (11) qui débouche aux extrémités opposées (9, 10) dudit corps (20), ce dernier étant couplé à un conduit de mise à l'air libre (6) dudit boîtier (1), le filtre (8) comprenant un élément filtrant qui se présente sous la forme d'une membrane hydrophobe (15), ledit élément filtrant en forme de membrane (15) étant incorporé dans le corps (20) du filtre (8) et établissant ainsi une combinaison intégrale entre ledit corps et ledit filtre, le filtre ainsi obtenu permettant de raccorder ledit boîtier à l'air libre tout en empêchant la pénétration d'eau et en limitant l'entrée d'humidité dans le boîtier, **caractérisé en ce que** ledit corps (20) comprend au moins deux parties (20A, 20B) formant un angle l'une par rapport à l'autre, l'élément filtrant en forme de membrane (15) étant agencé à l'intérieur du conduit (11) ménagé à l'intérieur dudit corps (20) et étant associé audit conduit de manière à former avec lui un ensemble monobloc, l'élément filtrant (15) étant agencé transversalement à l'intérieur du conduit (11), l'élément filtrant en forme de membrane (15) étant positionné au niveau d'une discontinuité dudit conduit (11), ladite discontinuité consistant en une région angulaire (22) dudit conduit, ladite région (22) étant située dans la zone de raccordement entre deux parties adjacentes (20A, 20B) du corps (20) du filtre (8) qui forment un angle, et la surface de l'élément filtrant en forme de membrane (15) étant supérieure à la section transversale de chaque partie rectiligne du conduit (11).

2. Filtre selon la revendication 1, **caractérisé en ce que** l'élément filtrant en forme de membrane (15) est moulé d'un seul tenant avec le corps (20) du filtre (8).

3. Filtre selon la revendication 1, **caractérisé en ce qu'**il comprend, à l'intérieur dudit conduit (11), une pluralité de ressauts (30) qui dépassent de sa paroi vers l'intérieur, lesdits ressauts (30) définissant un labyrinthe à l'intérieur dudit conduit et étant présents entre une extrémité libre (10) du corps (20) et l'élément filtrant en forme de membrane (15), les ressauts (30) renforçant l'effet de blocage de l'eau susceptible d'avoir pénétré dans le conduit (11) par cette extrémité (10).

4. Filtre selon la revendication 1, **caractérisé en ce que** le conduit (11) a une section transversale variable.

5. Filtre selon la revendication 1, **caractérisé en ce que** son corps (20) est couplé à un appendice (7) du boîtier (1), appendice dans lequel est ménagé le conduit de mise à l'air libre (6) dudit boîtier.

6. Filtre selon la revendication 5, **caractérisé en ce que** le corps (20) présente une partie (20A) que l'on engage sur l'appendice (7), lequel appendice se trouve par conséquent inséré dans le conduit (11) du corps, des ressauts (40) dépassant d'une paroi (11A) dudit conduit (11) pour coopérer avec ledit appendice (7) afin d'assurer l'étanchéité une fois le couplage effectué.

7. Filtre selon la revendication 5, **caractérisé en ce que** le corps (20) présente une partie (20A) qui vient s'insérer dans le conduit de mise à l'air libre (6) dudit appendice (7), lequel appendice se trouve de ce fait à l'extérieur de ladite partie (20A), des ressauts (50) étant prévus sur la face externe de ladite partie (20A) pour coopérer avec la paroi (6K) dudit conduit (6) afin de l'étancher une fois le couplage effectué.
